# EUROPEAN PATENT APPLICATION

(11) **EP 0 608 967 A2**
(43) Date of publication of application: **03.08.1994**
(21) Application number: 94200916.8
(22) Date of filing: 16.02.1990
(51) Int. Cl.: G11C 7/00, G11C 11/419

(54) **Memory devices**

(30) Priority: 18.02.1989 JP 39039/89; 21.02.1989 JP 39410/89
(62) Divisional of application: 90301733.3
(71) Applicant: SONY CORPORATION, Tokyo (JP)
(72) Inventor: Suzuki, Hiroyuki, c/o Intellectual Property Div., Shinagawa-ku, Tokyo 141 (JP); Araki, Shigeo, c/o Intellectual Property Div., Shinagawa-ku, Tokyo 141 (JP)
(74) Representative: Cotter, Ivan John

(57) **Abstract**

A semiconductor memory device includes bit lines (12, 13) and common data lines (14, 15) for writing data to or reading of data from plural memory cells (11). The bit lines (12, 13) and common data lines (14, 15) are provided with equalising circuits (21, 23) and/or precharging circuits (22, 24) which operate during address transition. Transition from writing to read-out is detected and used to actuate the equalising and/or precharging circuits more promptly than usual during such a transition in order to shorten the write recovery time to realise high speed operation. An output circuit (5) of the semiconductor memory device is provided with a precharging circuit (53, 54; 73, 74) for sensing and precharging the level on an output terminal (55; 75) to an intermediate level, thereby allowing a reduction in power consumption and ensuring a high speed outputting operation.

## Description

This invention relates to memory devices.

In general, in a static random access memory (SRAM), which is a type of semiconductor memory device, a signal potential difference is produced across a pair of bit lines or a pair of common data lines in order to effect data readout or data writing. For high speed readout or writing operations, it is necessary to change the logic level quickly. Thus, a known technique provides for shorting a pair of bit lines or a pair of common data lines, across which the signal potential difference is produced, for equalising the logic level for the next data. When bit lines having a logic level opposite to that of a memory cell of the SRAM are connected to the cell at the time of row selection, the data on the cell occasionally may be reversed. Thus, there is also known a precharging technique of transiently raising the bit line voltage towards the source voltage prior to row selection (word line selection) of the bit lines.

Such equalising or precharging is usually performed at the time of the writing or reading and before row selection. The timing is produced by an address transition detection circuit (ATD) operative to generate pulses upon address changes. For example, according to Japanese Patent Application Publication no. JP-A-57 74 884 or US Patent No. US-A-4 355 377, pulses are generated in the address transition detection circuit in response to address changes and are transmitted to a clock generator. The signals for controlling the equalising or precharging are outputted from the clock generator to actuate the equalising or precharging circuits provided on the bit line pairs to shorten the access time.

However, in general, during transition from the write operation to the readout operation, the bit lines or the common data lines are substantially in what is referred to as a fully swung state. For this reason, such an amount of time is needed for equalising or precharging that, when the speed is to be increased, it becomes difficult to terminate the equalising or precharging operation before word line selection.

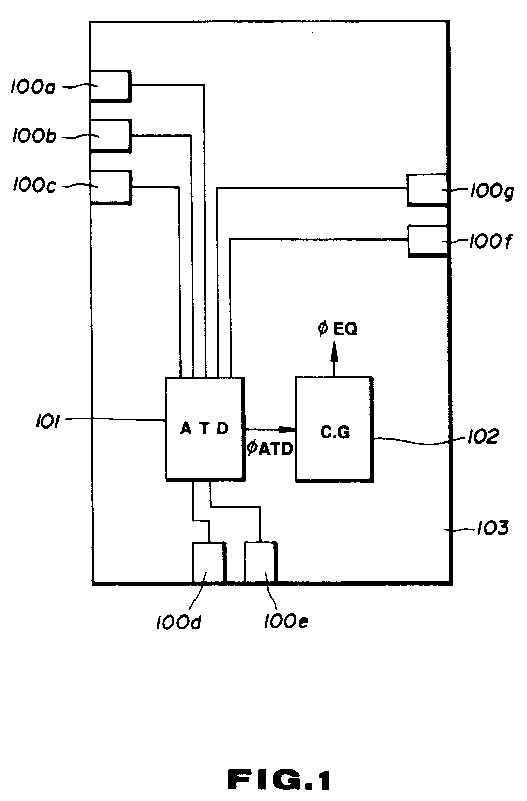

If pulses are produced more promptly from the address transition detection circuit, the equalising or precharging operation can be terminated more promptly. However, as shown diagrammatically in Figure 1 of the accompanying drawings, the address transition detection (ATD) circuit 101 collects the data at address inputs 100a to 100g, detects address data transitions and transmits a signal φATD comprising pulses to a clock generator (CG) 102. The address inputs 100a to 100g are widely distributed on a chip 103, so that it is extremely difficult to detect a data transition of each address at high speed. The greater the number of addresses, the larger is the scale of the address transition detection circuit 101 and the longer is the time involved until pulse generation.

The above-described problem arises during transition from writing to readout of the SRAM data. Additionally, the following further problem arises when the speed is to be increased in an output circuit of the SRAM.

The output signal from the output circuit (output buffer) usually has a binary logic level and the output circuit output data is at one of two levels, that is a high level (source voltage) and a low level (ground voltage). An example of such an output circuit is described in Japanese Patent Application Publication No. JP-A-62 214 583, in which a precharging circuit is formed at an output terminal of a final output stage to enable high speed swinging. The precharging circuit includes a respective MOS transistor connected between the output terminal and a source voltage line and between the output terminal and a ground voltage line. The MOS transistors are turned on by the equalising signal from an address buffer to effect the precharging operation. By virtue of such precharging operation, the output level is between the two logic levels, so that high speed swinging is realised at the time of ensuring swinging to the high or low level. However, the output circuit having the precharging circuit suffers from through-current flowing in the MOS transistors. That is, during precharging, both the MOS transistor connected between the output terminal and the source voltage line and the MOS transistor connected between the output terminal and the ground voltage line are turned on to permit a through-current to flow from the source voltage line towards the ground voltage line to increase power consumption.

According to an aspect of the invention there is provided a memory device that includes an output circuit having level detection means for detecting the level of an output signal having first and second levels, and a precharging circuit responsive to a signal from the level detection means to set the output signal to a third level between the first and second levels. The first level may be a high or low logic level, while the second level may be the logic level which is the inverse of the first level. The third level can be matched to an output decision level.

The level detection means of the output circuit may be operative to detect only the first level or the second level to generate a signal, or may be operative to detect both the first and the second levels to generate signals corresponding to these levels. The level detection means may be actuated by equalising signals, and constituted by a variety of logic circuits operating under voltage feedback from the output. In an arrangement for detecting only the first level or the second level, a switch may be provided between the output and the potential which is the inverse of the opposite logic level potential. In an arrangement for detecting both the first and the second levels, switches may be provided between both of these levels and the output. The switches may be constituted by respective MOS transistors.

Thus, a memory device having an output circuit capable of realising a high speed readout operation, with suppression of through-current, may be provided.

The third level, which may be the output decision level, may be matched, as an example, to a transistor-transistor logic (TTL) threshold value. This third level may be set with a small margin from the TTL threshold level to provide for high speed operation even with the same output level before and after the precharging operation. For precharging the low level, a level slightly lower than the threshold value of the TTL circuit may be used as the third level, whereas, for precharging the high level, a level slightly higher than the threshold value of the TTL circuit may be used as the third level. The third level may also be an intermediate level, such as 1/2 Vcc (source voltage), without being limited to the TTL threshold level.

According to another aspect of the invention there is provided a memory device as set out in claim 1.

Embodiments of the invention described in detail hereinbelow provide a semiconductor memory device that can be arranged for use as a static random access memory (SRAM), and which has a large capacity and can operate at high speed.

The invention will now be further described, by way of illustrative and non-limiting example, with reference to the accompanying drawings, in which:
Figure 1 is a diagrammatic view of a chip of a previously proposed semiconductor memory device;
Figure 2 is a block diagram showing the arrangement of a typical semiconductor memory device embodying the invention;
Figure 3 is a circuit diagram showing parts of the device of Figure 2;
Figure 4 is a timing chart showing the operation of a φEQW generating circuit of the device of Figure 2;
Figure 5 is a circuit diagram showing an example of the φEQW generating circuit;
Figure 6 is a timing chart for illustrating the operation of the device of Figure 2;
Figure 7 is a circuit diagram showing an example of an output circuit of the device of Figure 2;
Figure 8 is a timing chart for illustrating the operation of the output circuit of Figure 7;
Figure 9 is a circuit diagram showing another example of the output circuit of the device of Figure 2; and
Figure 10 is a waveform diagram of voltage and current during readout of an example of the output circuit of a semiconductor memory device embodying the invention.

A SRAM forming a preferred illustrative embodiment of the invention will now be described in detail with reference to the drawings.

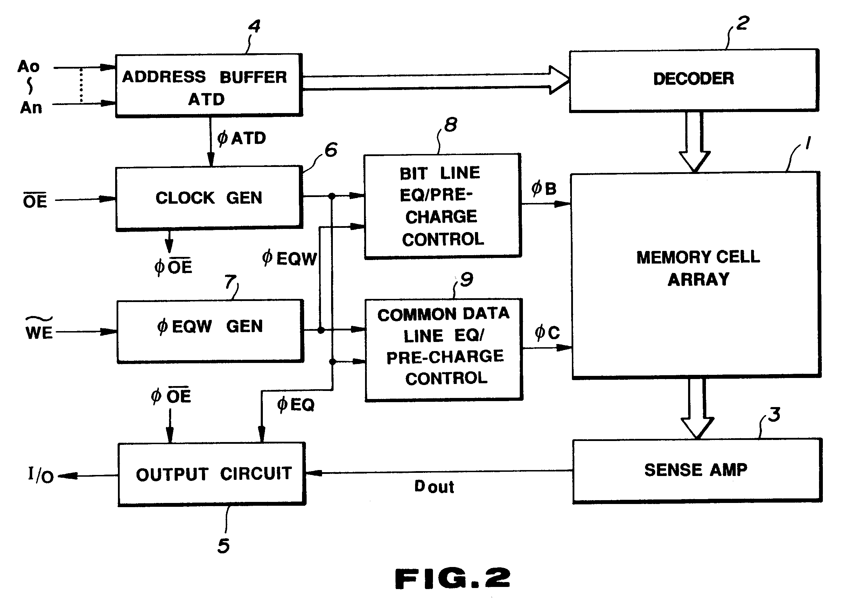

Figure 2 shows schematically the overall construction of the SRAM, which is of complementary metal oxide semiconductor (CMOS) structure. The circuitry of the SRAM is constituted by MOS transistors formed on a major surface of a semiconductor substrate and includes an address buffer-address transition detection (ATD) circuit 4 to which address signals AO to An are inputted and from which address data are transmitted to a decoder 2. Memory cell selection signals are transmitted from the decoder 2 to a memory cell array 1 where a desired memory cell is selected and corresponding data are read out. The data from the memory cell array 1 are amplified by a sense amplifier 3 from which data output signals Dout are transmitted to an output circuit 5.

An address transition detection signal φATD, which is a pulse signal comprising pulses generated by transitions of the address signals AO to An, is outputted from the address buffer-ATD circuit 4 and transmitted to a clock generator 6, in which an equalising pulse signal φEQ is generated on the basis of the pulses of the address transition detection signal φATD. An output enable signal $\overline{\text{OE}}$ is inputted from outside to the clock generator 6 so as to be supplied to the output circuit 5 as a signal φ$\overline{\text{OE}}$. The equalising signal φEQ is also transmitted to the output circuit 5. Thus, the data signal Dout, the equalising signal φEQ and the signal φ$\overline{\text{OE}}$ are transmitted to the output circuit 5, where outputting and precharging operations are performed as will be described subsequently.

The equalising signal φEQ is transmitted to a bit line equalising precharging control circuit 8 and is simultaneously transmitted to a common data line equalising and precharging control circuit 9. A signal 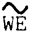 which undergoes transition from the time of writing until reading is transmitted to a φEQW generator 7. A signal φEQW from the generator 7 is transmitted to the bit line equalising and precharging control circuit 8 and to the common data line equalising and precharging control circuit 9. Thus, the control circuits 8 and 9 are controlled not only by the equalising signal φEQ, but also by the signal φEQW.

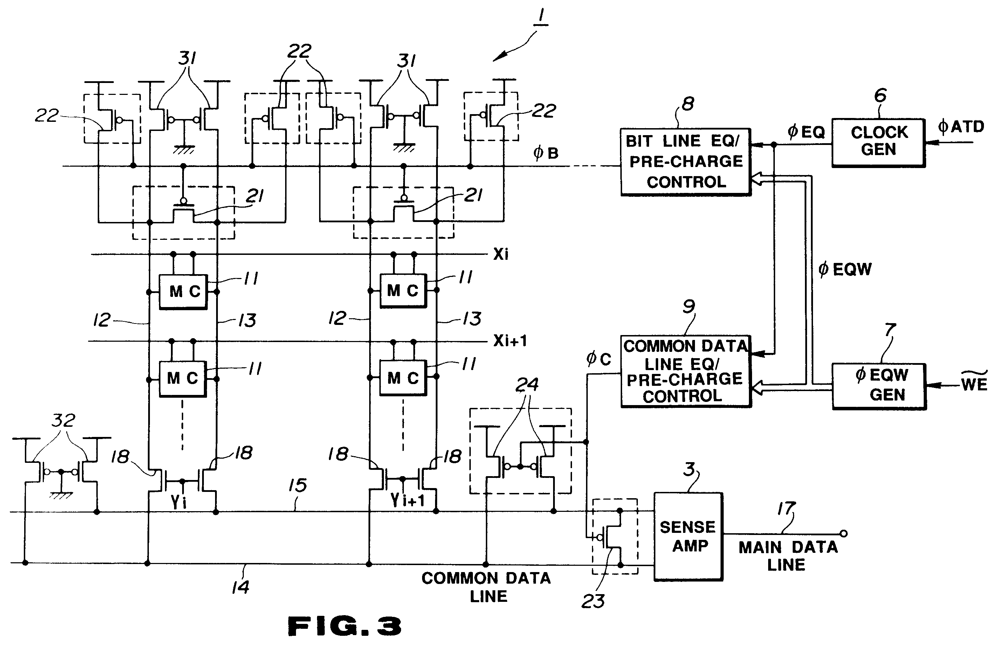

The memory cell array 1 and peripheral circuitry are shown in Figure 3. A number of memory cells (MC) 11 are arrayed in a matrix configuration with each cell 11 being connected to a pair of bit lines 12, 13. The memory cells 11 comprise flip-flops for data storage. A potential difference is produced across the bit lines 12, 13 at the time of reading and writing. Word lines Xi, Xi+1, ... , arranged at right angles to the bit lines 12, 13, are connected to the memory cells 11. Signals from a row decoder bring the word lines Xi, Xi+1, ... to a high level at the time of row selection to turn on word transistors (not shown) of the memory cells 11. A source or a drain of a pMOS transistor 21 is connected to each pair of bit lines 12, 13. Each pMOS transistor 21 constitutes a bit line equalising circuit and can short-circuit the associated bit line pair 12, 13. A signal φB from the bit line equalising and precharging control circuit 8 is supplied to the gate of each pMOS transistor 21. Between each bit line of each bit line pair 12, 13 and the high level source voltage there is connected a pMOS transistor 22 which constitutes a bit line precharging circuit and which has its source and drain connected to a source voltage and to the bit line 12 or 13, respectively. The signal φB from the bit line equalising and precharging control circuit 8 is supplied to the gate of each pMOS transistor 22, similarly to the pMOS transistors 21. A bit line load transistor 31 is provided for terminating each of the bit lines 12, 13. Each bit line load transistor 31 has its source and gate connected to the source potential and to ground potential GND, respectively. A pair of nMOS transistors 18, 18, functioning as a column select switch, are connected across each bit line pair 12, 13. The bit lines 12 are connected via the nMOS transistors 18 to a common data line 14 of a common data line pair 14, 15 while the bit lines 13 are connected to the common data line 15 via the nMOS transistors 18. Common column select lines Yi, Yi+1, ... , which are selectively brought to a high level by signals from a column decoder (not shown), are connected to the gates of the nMOS transistors 18, 18 associated with the bit line pairs 12, 13. The signals from the column decoder are based on the address signals and function to select a specified one of the memory cells 11 in association with the word lines Xi, Xi+1, ... .

The common data line pair 14, 15 functions to select a specified number of bit line pairs 12, 13 in common to associated sense amplifiers 3. Each sense amplifier 3 is connected to the terminals of the common data lines 14, 15 for amplifying the signal potential difference across the lines 14, 15. A main data line 17 is taken out from the sense amplifier 3 for input/output and is used for data outputting. A pair of pMOS transistors 32, 32 functioning as a common data line load are connected across the common data lines 14, 15. The source and the drain of a pMOS transistor 23 are connected to the common data lines 14, 15. The pMOS transistor 23 constitutes a common data line equalising circuit and can short-circuit the common data line pair 14, 15. A signal φC from the common data line equalising and precharging control circuit 9 is supplied to the gate of the pMOS transistor 23. Between the common data line pair 14, 15 and the source voltage there are connected a pair of pMOS transistors 24, 24 constituting a common data line precharging circuit, with the source and the drain of each of the pMOS transistors 24, 24 being connected to the source potential and to a respective one of the common data lines 14, 15, respectively. The signal φC from the common data line equalising and precharging control circuit 9 is also transmitted to the gate of each of the pMOS transistors 24.

The circuitry for actuating the equalising and precharging circuitry will now be described. The equalising and the precharging operations for the bit lines 12, 13 are performed by the signal φB from the bit line equalising and precharging control circuit 8, while the equalising and the precharging operations for the common data lines 14, 15 are performed by the signal φC from the common data line equalising and precharging control circuit 9. In the case of transition from writing to reading, the bit line equalising and precharging control circuit 8 and the common data line equalising and precharging control circuit 9 perform a control operation in accordance with the pulse signal φEQW from the φEQW generator 7. Thus, in case of transition from writing to reading, as later described, a high speed equalising and precharging operation may be performed. In the case of other address transitions, the control circuits 8, 9 perform necessary control operations in accordance with the pulse signal φEQ generated by the clock generator 6 on the basis of the signal φATD from the address buffer-ATD circuit 4 (Figure 2).

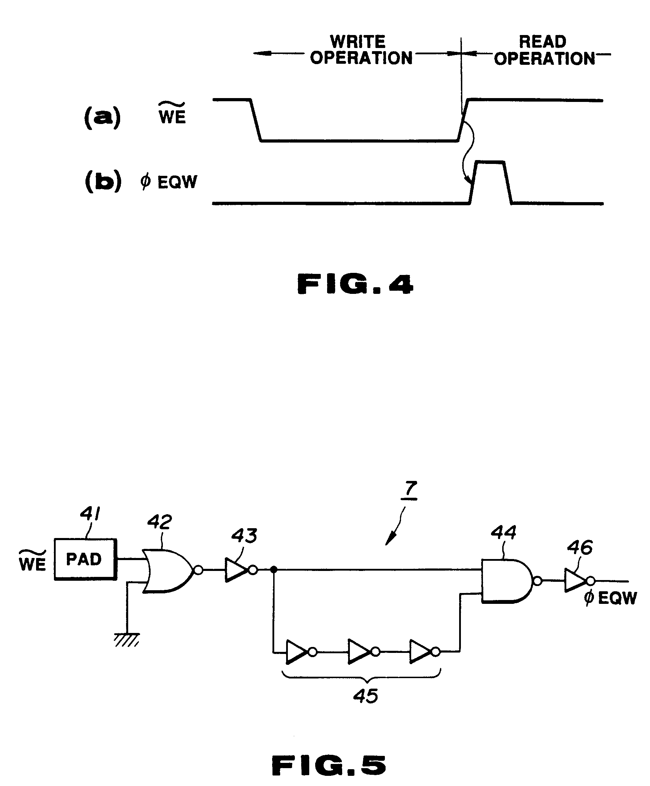

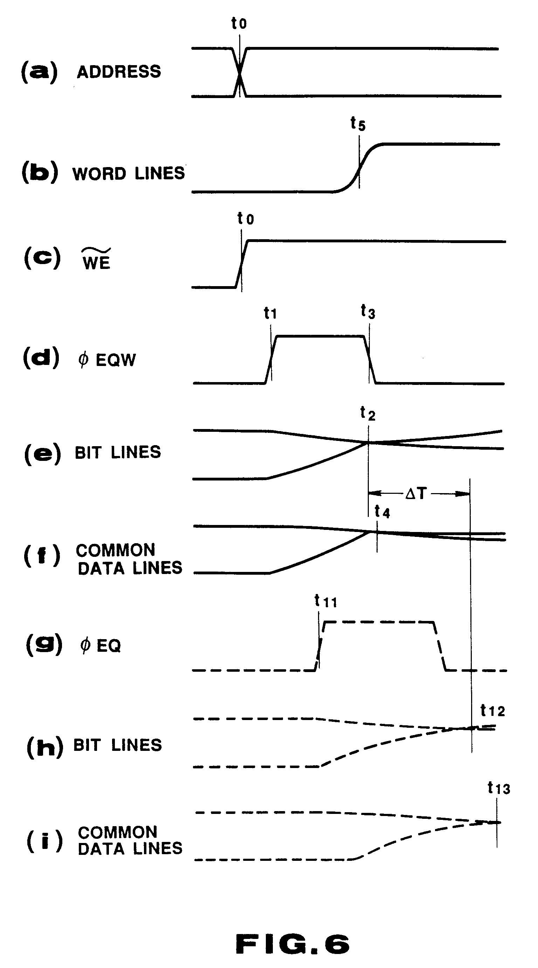

The φEQW generator 7 will now be described with reference to Figures 4 and 5. As shown in Figure 4, the φEQW generator 7 generates a pulse of the pulse signal φEQW when the write enable signal 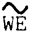 rises from low level to high level. When the write enable signal 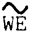 is at the low level or at the high level, the chip is set to the write state or to the reading state, respectively. Hence, the rising of the signal 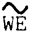 corresponds to the transition from writing to reading and this timing of transition may be used to achieve high speed equalising and precharging.

The circuit construction of the φEQW generator is shown in Figure 5. A pad 41, to which the signal 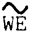 is inputted, is connected to an input terminal of a two-input NOR circuit 42, which has its other input terminal grounded, while an output of the NOR circuit 42 is inputted to one input terminal of a two-input NAND circuit 44 by way of an inverter 43. An output of the inverter 43 is connected to the other input terminal of the NAND circuit 44 by way of a delay circuit 45 consisting of plural stages of inverters. The delay circuit 45 determines the pulse width of the signal φEQW. An output of the NAND circuit 44 is transmitted as the pulse signal φEQW to the bit line equalising and precharging control circuit 8 and to the common data line equalising and precharging control circuit 9 by way of an inverter 46. In this manner, the φEQW generator 7 directly generates pulses from the signal 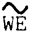 and collection of plural stages of address transitions is unnecessary so that the pulses of the signal φEQW may be transmitted at elevated speeds to the control circuits 8, 9 to shorten the write recovery time.

The operation of the above-described SRAM of the illustrative embodiment will now be explained with reference to Figures 3 and 6. The address signal shown at (a) in Figure 6 is changed at a time t0, at the same time that the write enable signal 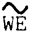 shown at (c) in Figure 6 is changed from the low level to the high level. With the write enable signal thus changed, the chip is switched from writing operation to reading operation.

The write enable signal is transmitted immediately to the φEQW generator 7 shown in Figure 3 and, at a time t1 after an extremely short time has elapsed, a pulse of the signal φEWQ is produced, as shown at (d) in Figure 6. This is because the pulse of the signal φEQW is generated with high response from the write enable signal by the φEQW generator 7. The thus-produced pulse of the signal φEQW is transmitted to the bit line equalising and precharging control circuit 8 and to the common data line equalising and precharging control circuit 9. The bit line equalising, bit line precharging, common data line equalising and common data line precharging operations are performed by the control signals φB, φC from the control circuits 8, 9. That is, at the bit lines 12, 13, the pMOS transistors 21 forming the bit line equalising circuits are turned on, while the pMOS transistors 22 forming the bit line precharging circuits are turned on. The result is that the level - shown at (e) in Figure 6 - at the bit line pair, which has been swung almost fully, is raised towards the source voltage when the current flows from the high level bit line to the low level bit line by equalising, with the precharging pMOS transistors 22 turned on, until the potentials at the bit lines 12, 13 become equal to each other at a time t2. At the time t2, or at a time t3, the pulse of the signal φEQW ends, that is the signal φEQW goes low, to terminate the equalising and precharging operation. Similarly, on the common data lines 14 and 15, the pMOS transistor 23 forming the common data line equalising circuit is turned on and the pMOS transistors 24 forming the common data line precharging circuit are turned on. The result is that the level - as shown at (f) in Figure 6 - at the common data line pair, which has been swung almost fully, is raised to the source voltage by the pMOS transistors 24, with the current flowing from the high level common data line to the low level common data line by equalisation, until the potentials at the common data lines 14, 15 become equal to each other at a time t4.

In this manner, the equalising and precharging operations are performed at the bit lines 12, 13 and the common data lines 14, 15 on the basis of the signal φEQW and, towards the close of these operations, the potential - shown at (b) in Figure 6 - of the word line to be selected is raised at a time t5 to effect the row selecting operation. In the word line selecting operation, the word transistors of the memory cells 11 of a given column are turned on to turn on the drive transistor to cause the signal potential difference to appear across the bit lines 12, 13. Such signal potential difference is also caused to appear on the common data lines 14, 15 by way of the pMOS transistors 18 forming the column select switch. The data are outputted and read out by way of the sense amplifiers 3.

For comparison, the operation of the equalising pulse signal φEQ based on the address buffer-ATD circuit 4 will now be explained with reference to signals shown by broken lines at (g) to (i) in Figure 6. After the change in the address signal at the time t0 and at the time of using the address buffer ATD circuit 4, a delay is caused and, at a time t11, a pulse of the signal φEQ - as shown at (g) in Figure 6 - is generated by the clock generator 6. As a result, the equalising and precharging operation for the level on the bit line - see (h) in Figure 6 - and the level on the common data line - see (i) in Figure 6 - is performed with a delay as compared to the case of the φEQW pulse signal. At a time t12 the levels of the bit line pair become equal, and, at a time t13, the levels of the common data line pair become equal. With a time difference of approximately ΔT at the bit lines as compared to the case of the pulse signal φEQW, it can be seen that a higher speed may be realised when the equalising and precharging operation is carried out by generating the pulses of the φEQW signal by the φEQW pulse generator 7 on the basis of the write enable signal 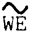 .

With the SRAM of the present embodiment, a pulse of the φEQW signal is generated at an elevated speed by the φEQW pulse generator 7 from the write enable signal 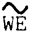 , at the time of transition from the write operation to the readout operation, despite the fully swung state of the bit lines and the common data lines, to perform the equalising and precharging operation, so that high speed access can be realised, while the word line can be selected at a high speed to prevent data destruction in the memory cell.

Although both the bit lines and the common data lines are both equalised and precharged in the above embodiment, it is possible for only the bit lines to be equalised and/or precharged and/or for only the common data lines to be equalised and/or precharged. Although the precharging and equalising circuits are each formed by pMOS transistors, other transistor types may also be used in combination. Similarly, for selecting the impedance, the threshold voltage Vth, the signal level supplied to the base or the gate, or the element size can be selected. The bit line load or the common data line load can be formed as variable load means.

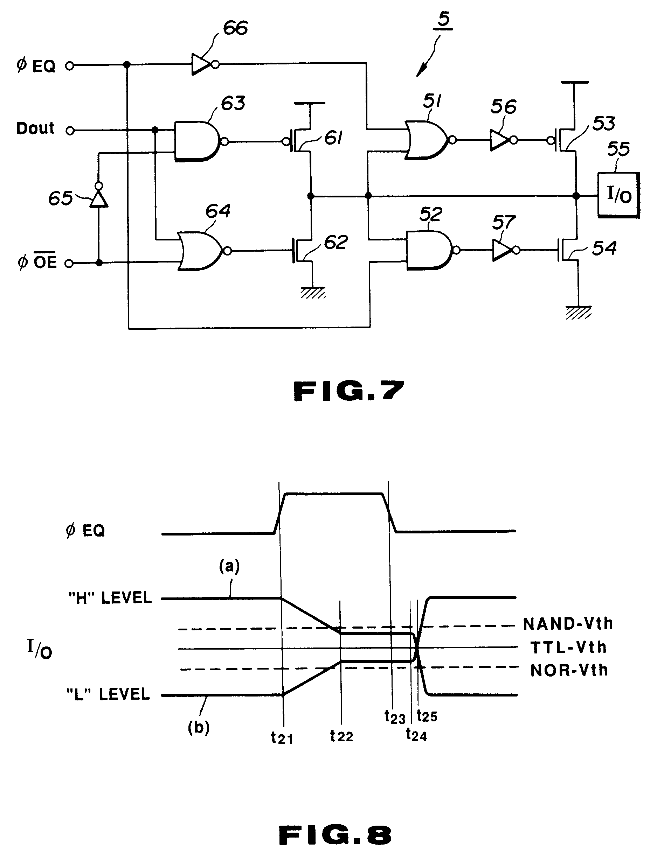

A way in which the output circuit 5 used as an output buffer on the SRAM of the present illustrative embodiment can be constructed will now be described with reference to Figures 7 and 8. The circuit construction of the output circuit 5 is shown in Figure 7. A portion functioning as the buffer per se is constituted by a two-input NAND circuit 63, a two-input NOR circuit 64, a pMOS transistor 61 and an nMOS transistor 62. The data signal Dout is supplied to one input terminal of the NOR circuit 64, while the signal φ$\overline{\text{OE}}$ is supplied to its other input terminal. The signal φ$\overline{\text{OE}}$ is supplied to one input terminal of the NAND circuit 63 by way of an inverter circuit 65, while the data signal Dout is supplied to its other input terminal. An output terminal of the NAND circuit 63 is connected to the gate of the pMOS transistor 61. An output terminal of the NOR circuit 64 is connected to the gate of the nMOS transistor 62. The pMOS transistor 61 and the nMOS transistor 62 are connected in series between the source voltage and the ground voltage. The pMOS transistor 61 has its source connected to the source voltage while the nMOS transistor 62 has its source connected to the ground voltage. The junction between the pMOS transistor 61 and the nMOS transistor 62 acts as an output (I/O) 55.

In addition to the circuit portion acting as the buffer, a further portion, now to be described, is provided for performing the precharging operation. A two-input NOR circuit 51 and a two-input NAND circuit 52 function as a level detection or sensor means. One input terminal of the NOR circuit 51 is supplied with the equalising signal φEQ by way of an inverter circuit 66. One input terminal of the NAND circuit 52 is directly supplied with the equalising signal φEQ. The other input terminals of the NOR circuit 51 and the NAND circuit 52 are connected to the output 55 for level detection. An output terminal of the NOR circuit 51 is connected via an inverter circuit 56 to the gate of a pMOS transistor 53, constituting a precharging circuit. An output terminal of the NAND circuit 52 is connected via an inverter circuit 57 to the gate of an nMOS transistor 54, similarly constituting a precharging circuit. The source of the pMOS transistor 53 is supplied with the source voltage, while its drain is connected to the output 55. The source of the nMOS transistor 54 is supplied with the ground voltage, while its drain is connected to the output 55.

The operation of the output circuit of Figure 7 will now be explained with reference to Figure 8. It is assumed that, before application of a pulse of the equalising signal φEQ, the signal level at the output 55, the data of the preceding access as shown by a waveform (a) in Figure 8, is at the high level ("H"). At the next access, the pulse of the equalising signal φEQ is generated at a time t21, the signal level of the equalising signal φEQ being at the high level. Thus, the high level signal is supplied to the one input terminal of the NAND circuit 52, while the low level signal is supplied to the one input terminal of the NOR circuit 51 by way of the inverter circuit 66. Since the output 55 is at the high level, the output of the NOR circuit 51, on detecting the high level at the output 55, is at the low level ("L"), while the gate voltage of the pMOS transistor 53, transmitted by way of the inverter circuit 56, is at the high level. Thus, the pMOS transistor 53 is turned off. The output of the NAND circuit 52, on detecting the high level at the output 55, is at the low level, while the gate voltage of the nMOS transistor 54, supplied by way of the inverter circuit 57, is at the high level. Thus, the nMOS transistor 54 is turned on. Hence, after the time t21, the pMOS transistor 53 is turned off, while the nMOS transistor 54 is turned on, with the potential at the output 55 being pulled towards the ground voltage. Since the pMOS transistor 53 is off, there is no through-current through the precharging circuit.

When the precharging is continued and the level at the output 55 is lowered, the level of the output 55 falling to a level lower than the threshold voltage (NAND-Vth) of the NAND circuit 52 for detecting the level, the output of the NAND circuit 52 goes to a high level at a time t22. As a result, the gate voltage of the nMOS transistor 54 falls to a low level and the nMOS transistor 54 is turned off to terminate the precharging operation. With the termination of the precharging operation, the voltage level at the output 55 is maintained at a level near the threshold voltage of the NAND circuit 52, so that high speed transition may be realised when swinging level to the high or low level.

At a time t23, the equalising signal φEQ falls to a low level. After this time, and until the next pulse of the φEQ signal is supplied, the output of the NAND circuit 52 and the output of the NOR circuit 51 are maintained at the high and low levels, respectively. As a result, the precharging circuit, formed by the pMOS transistor 53 and the nMOS transistor 54, is not in operation. When the falling of the equalising pulse is faster than the time t22, the level at the output 55 remains at the level to which the equalising pulse has fallen.

Data are then outputted by the inputting of the data signal Dout, at the timing of the signal φ$\overline{\text{OE}}$. If the input data signal Dout is at the low level, the output of the NAND circuit 63 is at the high level, the output of the NOR circuit 64 is at the high level, the pMOS transistor 61 is turned off and the nMOS transistor 62 is turned on. As a result, the level of the waveform shown at (a) in Figure 8 at a time t24 is lowered gradually, by the driving of the nMOS transistor 62, from the level exceeding the threshold voltage of the NAND circuit 52, until the level at the output 55 is changed to the low level, at a time t25, beyond the threshold voltage (TTL-Vth) of transistor-transistor logic (TTL).

If the data of the preceding cycle is at the low level, the level at the output 55 is initially at the low level, as shown by the waveform (b) in Figure 8. Then, at the time t21, the pulse of the equalising signal φEQ is supplied, the output of the NOR circuit 51 going to the high level and the output of the NAND circuit 52 going to the low level. The output of the inverter circuit 56 goes to the low level and the output of the inverter 57 goes to the high level, with the pMOS transistor 53 and the nMOS transistors 54 being turned on and off, respectively. Thus, the level of the output 55 is raised by the pMOS transistor 53, by way of the precharging operation.

The level at the output 55 exceeds, at the time t22, the threshold voltage (NOR-Vth) of the NOR circuit 51. The output of the NOR circuit 51 is changed from the high level to the low level to turn off the pMOS transistor 53 by means of the inverter circuit 56 to terminate the precharging operation. Then, supposing that after the falling at the time t23 of the equalising signal φEQ, a high level input is applied as the data signal Dout, the output of the NAND circuit 63 goes to the low level to turn on the pMOS transistor 61, so that the level of the output 55 is raised at the time t24, as shown by the waveform (b) in Figure 8, to exceed the TTL threshold voltage at the time t25.

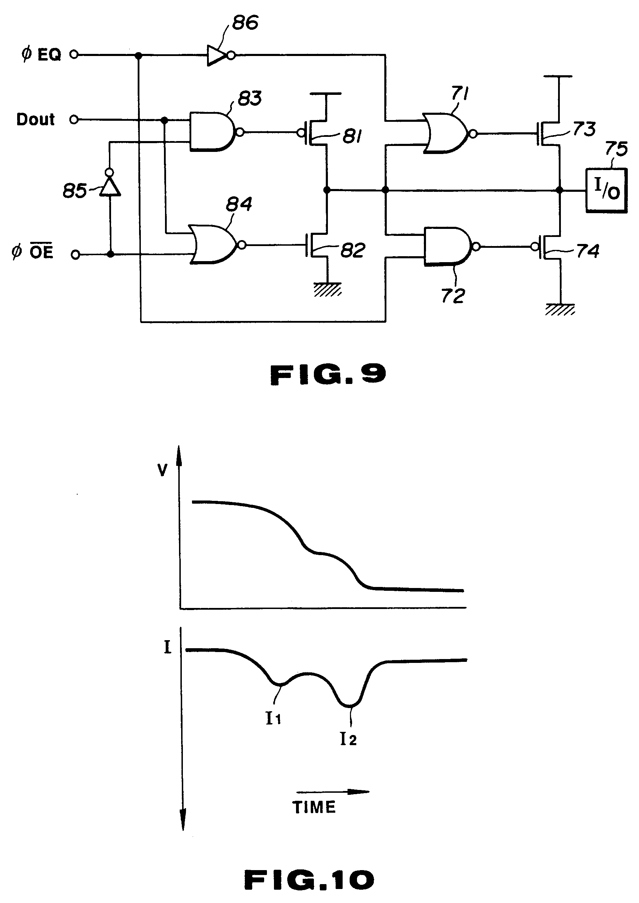

In the above-described SRAM output circuit, the NOR circuit 51 and the NAND circuit 52 operate in response to the level of the output 55 so that precharging occurs towards the reverse logic level potential. Most importantly, one of the pMOS transistor 53 and the nMOS transistor 54 constituting the precharging circuits is turned on by the NOR circuit 51 and the NAND circuit 52 forming the level detection means to suppress the through-current. Figure 10 shows changes in the voltage and the current when employing the present SRAM output circuit 5. Assuming that the voltage V is changed during readout from the high level to the low level, the current I flowing in the precharging operation is divided into smaller peaks I1 and I2 so that a current peak about one fifth that of conventional devices occurs.

In other words, the function of the output circuit 5 of suppressing the through-current is exhibited by the fact that the NAND circuit 52 and the NOR circuit 51, functioning together as the level detection means, have different threshold voltages (NAND-Vth and NOR-Vth), when the output level is between the threshold voltages, and that both the pMOS transistor 53 and the nMOS transistor 54 are turned off. It is possible to set the threshold voltages of the NAND circuit 52, the TTL circuit and the NOR circuit 51 to about 2V, 1.5V and 1.0 V, respectively. The difference between the threshold voltages of the level detection means and the output signal is preferably set with an allowance such that the threshold voltage of the output signal is not exceeded upon termination of precharging.

Although the centre of the output signal level is determined with the TTL threshold voltage as the reference, precharging can be made to any desired level between the source voltage and the ground voltage. The output circuit is not limited to the output buffer, but may be used in a buffer for data transfer in the memory device. Thus, it may be utilised for a circuit portion which has large wiring capacitance and where high speed can be realised by precharging. In addition, although the circuit is provided in the above illustrative embodiment for precharging to both high and low levels, precharging may be made only to one of the high or low sides. For example, the NAND circuit 52, the inverter circuit 57 and the nMOS transistors may be eliminated or, alternatively, the NOR circuit 51, the inverter circuit 56 and the pMOS transistor 53 may be eliminated.

Figure 9 shows a modification of the output circuit 5. The elements of the output circuit 5 of Figure 9 forming the circuit portion functioning as the buffer per se are a two-input NAND circuit 83, a two-input NOR circuit 84, a pMOS transistor 81 and an nMOS transistor 82. These elements are the same as corresponding ones of the output circuit 5 of Figure 7. Thus, the data signal Dout is supplied to one input terminal of the NOR circuit 84, while the signal φ$\overline{\text{OE}}$ is supplied to its other input terminal. The signal φ$\overline{\text{OE}}$ is supplied to one input terminal of the NAND circuit 83 by way of an inverter circuit 85, while the data signal Dout is supplied to its other input terminal. An output terminal of the NAND circuit 83 is connected to the gate of the pMOS transistor 81. An output terminal of the NOR circuit 84 is connected to the gate of the nMOS transistor 82. The pMOS transistor 81 and the nMOS transistor 82 are connected in series between the source voltage and the ground voltage. The source of the pMOS transistor 81 is connected to the source voltage while the source of the nMOS transistor 82 is connected to the ground potential. The junction of the drains of the pMOS transistor 81 and the nMOS transistor 82 acts as an output (I/O) 75.

The circuit portion taking charge of precharging is composed of a two-input NOR circuit 71, a two-input NAND circuit 72, an nMOS transistor 73 and a pMOS transistor 74. The NOR circuit 71 and the NOR circuit 72 function as level detection means. One input of the NOR circuit 71 is supplied with the equalising signal φEQ by way of an inverter circuit 86. One input of the NAND circuit 72 is supplied directly with the equalising signal φEQ. The other input terminals of the NOR circuit 71 and the NAND circuit 72 are connected for level detection to the output 75. An output terminal of the NOR circuit 71 is connected to the gate of the nMOS transistor 73, constituting a precharging circuit. An output terminal of the NAND circuit 72 is connected to the gate of the pMOS transistor 74, constituting a precharging circuit. The drain of the nMOS transistor 73 is supplied with a source voltage while its source is connected to the output 75. The drain of the pMOS transistor 74 is supplied with the ground potential, while its source is connected to the output 75.

While the modified output circuit of Figure 9, the precharging operation is started by the equalising signal φEQ supplied to the NOR circuit 71 and the NAND circuit 72. The level of the output 75 can be brought close to the TTL level with suppression of the through-current. The modification of Figure 9 differs from the circuit of Figure 7 in that the inverter circuits between the precharging circuits and the level detection means are eliminated and in that the sources of the nMOS transistor 73 and the pMOS transistor 74 are connected to the output 75. Thus, a rise or fall in voltage level when the output 75 is precharged may be stopped up to an amount corresponding to the threshold voltage of the pMOS transistor 74 or nMOS transistor 73. In addition, usage of space may be reduced by an amount corresponding to the inverter circuits connected to the gates of the MOS transistors.

## Claims

1. A memory device comprising
a semiconductor substrate having a major surface,
a plurality of memory cells (11) arranged on said major surface in a matrix configuration for data storage,
a plurality of pairs of bit lines (12, 13) formed on said major surface and coupled to each column of the memory cells (11) for handling complementary read-out data or write data,
a plurality of word lines (Xi etc) formed on said major surface, one for each row of the memory cells (11), for selecting rows of the memory cells,
a sense amplifier (3) arranged on said major surface between each pair of bit lines (12, 13) for amplifying the voltage across each pair of bit lines to produce an output signal, and
an output circuit (5) for amplifying the output signal from said sense amplifier (3), the output circuit (5) including
an output terminal (55;75) for outputting the amplified output signal from the sense amplifier (3),
output means (61, 62; 81, 82) for driving said output terminal (55; 75) to a first level or a second level,
level detection means (51, 52; 71, 72) for detecting the level at said output terminal (55; 75), and
precharging means (53, 54; 73, 74) responsive to a signal from said level detection means (51, 52; 71, 72) to precharge the level at said output terminal to a third level between the first level and the second level.

2. A memory device according to claim 1, wherein the level detection means (51, 52; 71, 72) is operative transiently in response to an equalising signal generated in response to address transitions.

3. A memory device according to claim 1 or claim 2, wherein the precharging means (53, 54) includes an MOS transistor (53, 54) having a drain connected at least to said output terminal (55) and having a gate connected to an output of the level detection means (51, 52).

4. A memory device according to claim 1 or claim 2, wherein the precharging means (73, 74) comprises an MOS transistor (73, 74) having a source connected at least to said output terminal (75) and having a gate connected to an output of the level detection means (71, 72).

5. A memory device according to claim 1, wherein said third level is an output decision level.

6. A memory device according to claim 1, wherein the first level is a source voltage, the second level is a ground voltage, and the third level is a TTL compatible output decision level.
